# EUROPEAN PATENT APPLICATION

(11) **EP 2 492 977 A2**
(43) Date of publication of application: **29.08.2012**
(21) Application number: 11174876.0
(22) Date of filing: 21.07.2011
(51) Int. Cl.: H01L 33/44, H01L 33/50, H01L 33/56

(54) **Light emitting diode**

(30) Priority: 25.02.2011 KR 20110017063
(71) Applicant: Samsung Electronics Co., Ltd., Gyeonggi-do (KR)
(72) Inventor: Lee, Yeong-Bae, 105-2001 Gyeonggi-do (KR); Shin, Myeong-Ju, 5-505 Seoul (KR); Baek, Seung Hwan, 227-1003 Seoul (KR)
(74) Representative: Dr. Weitzel & Partner

(57) **Abstract**

A light emitting diode ("LED"1) includes a substrate (100), a light emitting unit (140) on the substrate and generating light, an encapsulation layer (200) overlapping an entire of exposed surfaces of the light emitting unit, and a coating layer (300) including an organic material and on the encapsulation layer. A refractive index of the coating layer is greater than a refractive index of air and less than a refractive index of the encapsulation layer.

## Description

### BACKGROUND OF THE INVENTION

### (a) Field of the Invention

The invention is a light emitting diode ("LED").

### (b) Description of the Related Art

A LED is basically made of a semiconductor junction of a p-type and an n-type, and is an element using a light emitting semiconductor emitting energy corresponding to a band gap of the semiconductor as a light formed by the combination of electrons and holes under a voltage application. The LED has various merits such as a small size and a light weight, a longer lifetime, less heat production, and a high response speed compared with a conventional light bulb, and thereby is used for various electrical and electronic products.

The LED generally includes an LED chip, and a sealant to protect the LED chip. The sealant is conventionally formed of a material such as silicon resin, however it has weak protection against moisture.

Also, the refractive index of the material used in the structure of the LED is much larger than the refractive index of the atmosphere such that reflection is seriously generated, thereby decreasing light efficiency.

The above information disclosed in this Background section is only for enhancement of understanding of the background of the invention and therefore it may contain information that does not form the prior art that is already known in this country to a person of ordinary skill in the art.

### BRIEF SUMMARY OF THE INVENTION

Exemplary embodiments of the present invention provides a light emitting diode ("LED") including a coating layer preventing light loss by reflection and having moisture resistance.

A exemplary embodiment of the present invention provides a LED including a substrate, a light emitting unit on the substrate and generating light, an encapsulation layer covering the light emitting unit, and a coating layer including an organic material and on the encapsulation layer. A refractive index of the coating layer is greater than a refractive index of air and less than a refractive index of the encapsulation layer.

The coating layer may include at least one of oleic acid, palmitic acid, eicosenoic acid, and erucic acid.

The encapsulation layer may include a phosphor therein.

The phosphor may be an oxide group compound or a nitride group compound.

The phosphor may include a nitride crystal or oxynitride crystal including europium (Eu) among a crystal having a β type silicon nitride (Si₃N₄) crystal structure.

The phosphor may include at least one of (Ba,Sr,Ca)₂SiO₄:Eu₂+, Ba₂MgSi₂O₇:Eu₂+, Ba₂ZnSi₂O₇:Eu₂+, BaAl₂O₄:Eu₂+, SrAl₂O₄:Eu₂+, BaMgAl₁₀O₁₇:Eu₂+, Mn₂+, and BaMg₂Al₁₆O₂₇:Eu₂+ of a green wavelength range.

The phosphor may include at least one of BaMg₂Al₁₆O₂₇:EU₂+, Sr₄Al₁₄O₂₅:Eu₂+, BaAl₁₈O₁₃:Eu₂+, (Sr,Mg,Ca,Ba)₅(PO₄)₃Cl:Eu₂+, and Sr₂Si₃O₈ - 2SrCl₂:Eu₂+ of a blue wavelength range.

The phosphor may include at least one of Y₂O₃:Eu₃+, Bi₃+, (Sr,Ca,Ba,Mg,Zn)₂P₂O₇:Eu₂+, Mn₂+, (Ca,Sr,Ba,Mg,Zn)₁₀ (PO₄)₆(F,Cl,Br,OH)₂:Eu₂+, Mn₂+, (Gd,Y,Lu,La)₂O₃:Eu₃+, Bi₃+, (Gd,Y,Lu,La)BO₃:Eu₃+, Bi₃+, (Gd,Y, Lu, La) (P,V)O₄:Eu₃+, Bi₃+, (Ba,Sr,Ca)MgP₂O:Eu₂+, Mn₂+, (Y,Lu)₂WO₆:Eu₃+, Mo₆+, (Sr,Ca,Ba,Mg,Zn)₂SiO₄:Eu₂+, and Mn₂+ as an oxide group, or (Sr,Ca)AlSiN₃:Eu₂+, (Ba,Sr,Ca)₂Si₅N₈:Eu₂+, or (Ba,Sr,Ca)₂Sio₄₋ₓN_{y}:Eu₂+ as a nitride group of a red wavelength range.

The encapsulation layer may include an epoxy resin or silicon resin.

The light which is generated by the light emitting unit may pass through the encapsulation layer and the coating layer in sequence.

The coating layer may include a lower layer, and an upper layer disposed on the lower layer. The upper layer includes a material having a lower refractive index than a material of the lower layer.

A mold frame may be on an upper surface of the substrate, and the light emitting unit and the encapsulation layer may be inside the mold frame.

The coating layer may be extended from the encapsulation layer and may overlap a portion of a lateral side of the mold frame.

The encapsulation layer may include dual layers having different refractive indexes.

The encapsulation layer may include a lower encapsulation layer covering the light emitting unit, and an upper encapsulation layer on the lower encapsulation layer. A refractive index of the upper encapsulation layer is smaller than a refractive index of the lower encapsulation layer.

In exemplary embodiments of the invention, the coating layer may include a material having strong moisture resistance. The coating layer reduces the difference between the refractive index of the LED and the refractive index of the atmosphere such that reliability and light efficiency may be simultaneously improved.

### BRIEF DESCRIPTION OF THE DRAWINGS

The above and other features of this disclosure will become more apparent by describing in further detail exemplary embodiments thereof with reference to the accompanying drawings, in which:
FIG. 1 is a cross-sectional view of an exemplary embodiment of a light emitting diode ("LED") according to the invention.
FIG. 2 is a cross-sectional view of another exemplary embodiment of a LED according to the invention.
FIG. 3 is a cross-sectional view of another exemplary embodiment of a LED according to the invention.

### DETAILED DESCRIPTION OF THE INVENTION

The invention will be described more fully hereinafter with reference to the accompanying drawings, in which exemplary embodiments of the invention are shown. However, it is to be understood that the invention is not limited to the disclosed embodiments, but, on the contrary, is intended to cover various modifications. As those skilled in the art would realize, the described embodiments may be modified in various different ways, all without departing from the spirit or scope of the invention.

In the drawings, the thickness of layers, films, panels, regions, etc., are exaggerated for clarity. It will be understood that when an element such as a layer, film, region, or substrate is referred to as being "on" another element, it can be directly on the other element or intervening elements may also be present. Like reference numerals designate like elements throughout the specification.

It will be understood that, although the terms first, second, third, etc., may be used herein to describe various elements, components, regions, layers and/or sections, these elements, components, regions, layers and/or sections should not be limited by these terms. These terms are only used to distinguish one element, component, region, layer or section from another region, layer or section. Thus, a first element, component, region, layer or section discussed below could be termed a second element, component, region, layer or section without departing from the teachings of the invention.

Spatially relative terms, such as "lower," "upper" and the like, may be used herein for ease of description to describe the relationship of one element or feature to another element(s) or feature(s) as illustrated in the figures. It will be understood that the spatially relative terms are intended to encompass different orientations of the device in use or operation, in addition to the orientation depicted in the figures. For example, if the device in the figures is turned over, elements described as "lower" relative to other elements or features would then be oriented "upper" relative to the other elements or features. Thus, the exemplary term "below" can encompass both an orientation of above and below. The device may be otherwise oriented (rotated 90 degrees or at other orientations) and the spatially relative descriptors used herein interpreted accordingly.

The terminology used herein is for the purpose of describing particular embodiments only and is not intended to be limiting of the invention. As used herein, the singular forms "a," "an" and "the" are intended to include the plural forms as well, unless the context clearly indicates otherwise. It will be further understood that the terms "comprises" and/or "comprising," when used in this specification, specify the presence of stated features, integers, steps, operations, elements, and/or components, but do not preclude the presence or addition of one or more other features, integers, steps, operations, elements, components, and/or groups thereof.

Embodiments of the invention are described herein with reference to cross-section illustrations that are schematic illustrations of idealized embodiments (and intermediate structures) of the invention. As such, variations from the shapes of the illustrations as a result, for example, of manufacturing techniques and/or tolerances, are to be expected. Thus, embodiments of the invention should not be construed as limited to the particular shapes of regions illustrated herein but are to include deviations in shapes that result, for example, from manufacturing.

Unless otherwise defined, all terms (including technical and scientific terms) used herein have the same meaning as commonly understood by one of ordinary skill in the art to which this invention belongs. It will be further understood that terms, such as those defined in commonly used dictionaries, should be interpreted as having a meaning that is consistent with their meaning in the context of the relevant art and will not be interpreted in an idealized or overly formal sense unless expressly so defined herein.

All methods described herein can be performed in a suitable order unless otherwise indicated herein or otherwise clearly contradicted by context. The use of any and all examples, or exemplary language (e.g., "such as"), is intended merely to better illustrate the invention and does not pose a limitation on the scope of the invention unless otherwise claimed. No language in the specification should be construed as indicating any non-claimed element as essential to the practice of the invention as used herein.

Hereinafter, the invention will be described in detail with reference to the accompanying drawings.

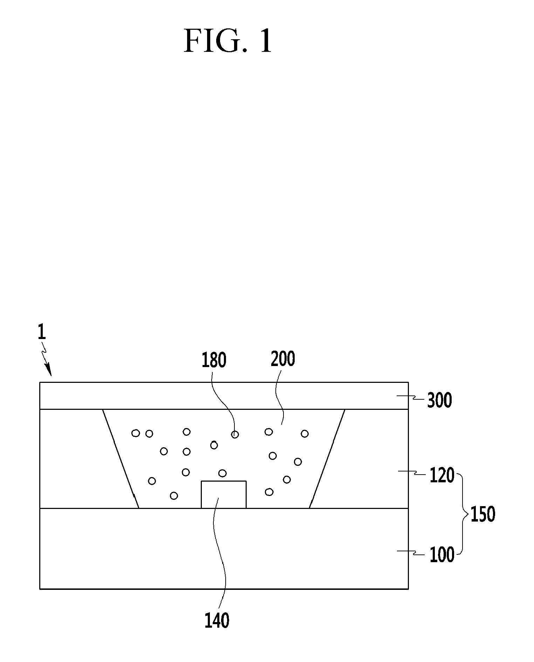

FIG. 1 is a cross-sectional view of an exemplary embodiment of a light emitting diode ("LED") according to the invention.

Referring to FIG. 1, a LED 1 according to the illustrated exemplary embodiment includes a substrate 100, a mold frame 120 on and overlapping an outer part of the substrate 100, and a light emitting unit 140 positioned on an exposed portion substrate 100 enclosed by the mold frame 120. The substrate 100 and the mold frame 120 may be integrally formed, such that the substrate 100 and the mold frame 120 collectively form a single, unitary, indivisible member.

A package 150 including the substrate 100 and the mold frame 120 functions to protect the light emitting unit 140 from external moisture.

The LED 1 includes an encapsulation layer 200 completely filling the space between the mold frame 120 and the light emitting unit 140. The encapsulation layer 200 includes a phosphor 180 dispersed therein.

Although not shown, the light emitting unit 140 also includes a light emitting chip and a lead pattern, and may include wiring connecting the light emitting chip and the lead pattern to each other. The lead pattern as an electrode pattern functions to apply external power to the light emitting chip.

The light emitting chip as a horizontal type of light emitting chip in which an N-type electrode and a P-type electrode on a same plane is mounted on the lead pattern. A vertical type of light emitting chip including an upper P-type electrode and a lower N-type electrode may also be used.

The encapsulation layer 200 functions to protect the light emitting unit 140 by encapsulating the light emitting unit 140, and the phosphor 180 dispersed inside the encapsulation layer 200 includes green phosphor and red phosphor that are mixed, thereby emitting red and green light according when light is incident thereto. The light emitting unit 140 may be a blue light emitting chip, and blue light emitted from the blue light emitting chip, red light, and green light are mixed, thereby outputting white light.

The phosphor 180 included in the LED 1 according to the illustrated exemplary embodiment may include an oxide group compound or a nitride group compound. The phosphor 180 according to the illustrated exemplary embodiment may include a crystal of a nitride or an oxynitride including europium (Eu) among a crystal structure of a β type of silicon nitride (Si₃N₄).

The phosphor 180 according to the illustrated exemplary embodiment may include at least one of (Ba,Sr,Ca)₂SiO₄-Eu₂+, Ba₂MgSi₂O₇:Eu₂+, Ba₂ZnSi₂O₇:Eu₂⁺, BaAl₂O₄:Eu₂+, SrAl₂O₄:Eu₂+, BaMgAl₁₀O₁₇:Eu₂+, Mn₂+, and BaMg₂Al₁₆O₂₇:Eu₂+ that are included in a green wavelength range. The materials for the above-described phosphor 180 may be used alone or as a mixture.

The phosphor 180 according to another exemplary embodiment may include at least one of BaMg₂Al₁₆O₂₇:Eu₂+, Sr₄Al₁₄O₂₅:Eu₂+,BaAl₁₈O₁₃:Eu₂+, (Sr,Mg,Ca,Ba)₅(PO₄)₃Cl:Eu₂+, and Sr₂Si₃O₈ · 2SrCl₂:Eu₂+ that are included in a blue wavelength range.

The phosphor 180 according to another exemplary embodiment may include at least one of Y₂O₃:Eu₃+, Bi₃+, (Sr,Ca,Ba,Mg,Zn)₂P₂O₇:Eu₂+, Mn₂+, (Ca,Sr,Ba,Mg,Zn)₁₀(PO₄)₆(F,Cl,Br,OH)₂:Eu₂+, Mn₂+, (Gd,Y,Lu,La)₂O₃:Eu₃+, Bi₃+, (Gd,Y,Lu,La)BO₃:Eu₃+, Bi₃+, (Gd,Y,Lu,La)(P,V)O₄:Eu₃+, Bi₃+, (Ba,Sr,Ca)MgP₂O₇:Eu₂+, Mn₂+, (Y,Lu)₂WO₆:Eu₃+, Mo₆+, (Sr,Ca,Ba,Mg,Zn)₂SiO₄:Eu₂+ and Mn₂+ among the oxide group, or (Sr,Ca)AlSiN₃:Eu₂+, (Ba,Sr,Ca)₂Si₅N₈:Eu₂+, and (Ba₇Sr,Ca)₂SiO₄₋ₓN_{y}:Eu₂+ among the nitride group, which are included in a red wavelength range.

The phosphor 180 according to the illustrated exemplary embodiment including the materials described above has excellent thermal stability and optimized spectrum matching along with a color filter for a liquid crystal display ("LCD"), thereby realizing excellent luminance and color reproducibility.

The encapsulation layer 200 may include a transparent silicon resin or epoxy resin, and an opaque resin of a degree that light may pass according to usage of the LED.

The LED 1 according to the illustrated exemplary embodiment includes a coating layer 300 directly on the encapsulation layer 200. The coating layer 300 covers the encapsulation layer 200 and the mold frame 120, and although not shown, the coating layer 300 is extended to cover the side of the package 150. The LED 1 includes a space formed by the mold frame 120, the light emitting unit 140 and the coating layer 300, and the encapsulation layer 200 completely fills the space.

The coating layer 300 according to the illustrated exemplary embodiment may include an organic material having a refractive index between the refractive index of the light emitting unit 140 and the refractive index of the atmosphere.

The coating layer 300 according to the illustrated exemplary embodiment may include at least one of oleic acid, palmitic acid, eicosenoic acid, and erucic acid shown in Table 1 below.

**[Table 1]**

| Title | Molecular formula | Structure | Refractive Index |
|---|---|---|---|
| Oleic acid | C₁₈H₃₄O₂ | 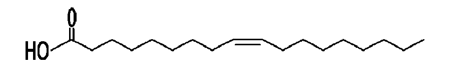 | 1.454 |
| Palmitic acid | C₁₆H₃₂O₂ | 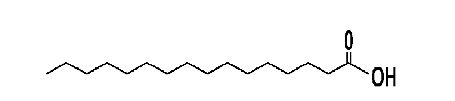 | 1.425 |
| Eicosenoic acid | C₂₀ H₃₈O₂ | 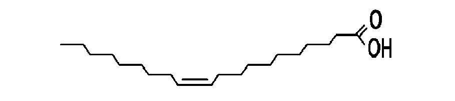 | 1.456 |
| Erucic acid | C₂₂H₄₂O₂ | 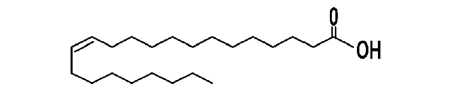 | 1.457 |

The materials of the coating layer 300 according to the illustrated exemplary embodiment include many hydrophobic functional groups such that penetration of external moisture into the light emitting unit 140 may be reduced or effectively prevented. As an experimental result, the luminance of a non-coated LED is 7.90 candelas (cd), however the luminance of a LED that is coated with oleic acid according to the illustrated exemplary embodiment is 8.24 cd, thereby being improved by about 4% over the non-coated LED.

***Also, the coating layer 300 has a refractive index between the refractive index of air of 1 and the refractive index of the encapsulation layer 200 including silicon resin of about 1.54, such that the degree of total reflection may be reduced when the light generated from the light emitting unit 140 passes through the encapsulation layer 200 and is incident to the air. In other words, a critical angle (an angle at which total reflection is generated) by which the light generated by the light emitting unit 140 passes through the encapsulation layer 200 and is emitted to the air may be increased.***

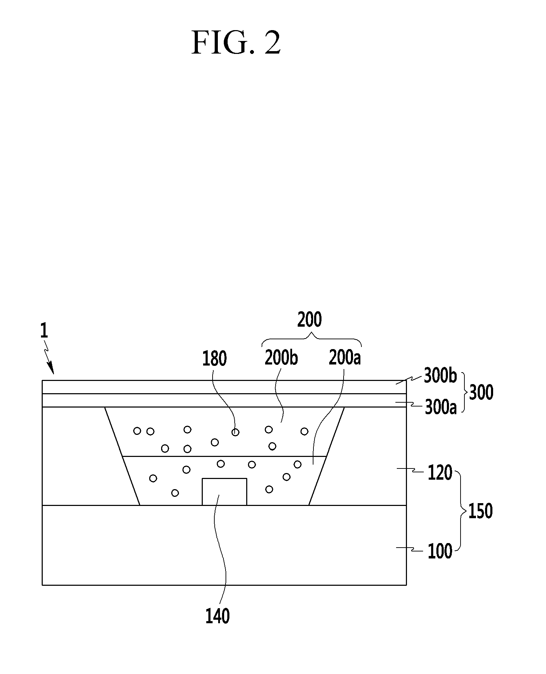

FIG. 2 is a cross-sectional view of another exemplary embodiment of a LED according to the invention.

The LED 1 according to the exemplary embodiment of FIG. 2 mostly has the same constitution as the LED according to the exemplary embodiment of FIG. 1. Accordingly, only portions having differences from the LED according to the exemplary embodiment of FIG. 1 will be described. The remaining portions may be applied with the description of the exemplary embodiment of FIG. 1.

A coating layer 300 according to the illustrated exemplary embodiment includes a lower layer 300a, and an upper layer 300b positioned directly on the lower layer 300a. The upper layer 300b may include a material having a lower refractive index than the lower layer 300a. The coating layer 300 according to the illustrated exemplary embodiment is not limited to the dual-layer structure including the lower layer 300a and the upper layer 300b, and may include a plurality of layers having refractive indexes that are gradually decreased closer to the air from the encapsulation layer 200. The light efficiency may be further improved through this structure.

The encapsulation layer 200 according to the illustrated exemplary embodiment includes a lower encapsulation layer 200a covering all exposed surfaces of the light emitting unit 140, and an upper encapsulation layer 200b positioned directly on the lower encapsulation layer 200a. Here, the upper encapsulation layer 200b may have a lower refractive index than the lower encapsulation layer 200a. The light emitting chip included in the light emitting unit 140 may include gallium nitride (GaN), whereby the refractive index of the light emitting unit 140 is about 2.32. Here, the refractive index of the lower encapsulation layer 200a may be about 2.0 and the refractive index of the upper encapsulation layer 200b may be about 1.7.

The encapsulation layer 200 according to the illustrated exemplary embodiment is not limited to the dual-layer structure including the lower encapsulation layer 200a and the upper encapsulation layer 200b, and may include a plurality of layers having refractive indexes that are gradually decreased closer to the coating layer 300 from the light emitting unit 140. The light efficiency may be further improved through this structure.

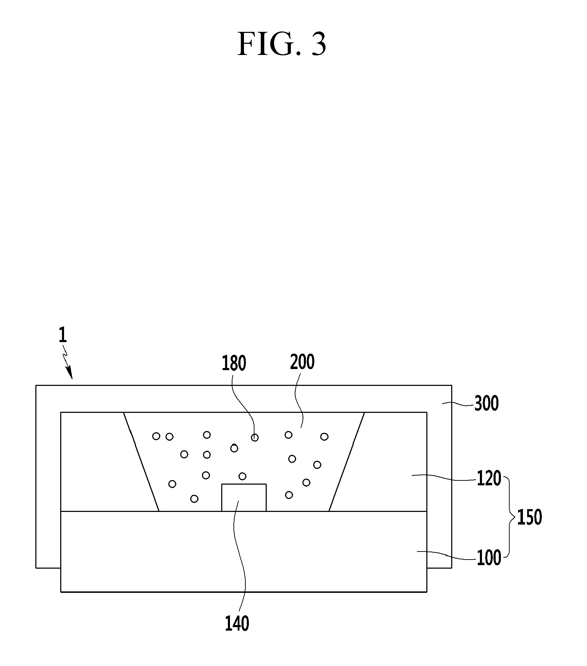

FIG. 3 is a cross-sectional view of another exemplary embodiment of a LED according to the invention.

Referring to FIG. 3, the structure of the coating layer 300 covers an entire of an upper surface of the LED 1 and a portion of side surfaces of the package 150. The coating layer 300 may overlap an entire of the side surfaces of the package 150, or may only overlap a portion of the side surfaces as illustrated in FIG. 3. In contrast, the coating layer according to the exemplary embodiment of FIG. 1 only overlaps an entire of the upper surface of the LED 1. Upper and lateral portions of the coating layer 300 collectively form a single, unitary, indivisible member.

While this invention has been described in connection with what is presently considered to be practical exemplary embodiments, it is to be understood that the invention is not limited to the disclosed embodiments, but, on the contrary, is intended to cover various modifications and equivalent arrangements included within the spirit and scope of the appended claims.

## Claims

1. A light emitting diode comprising:
a substrate;
a light emitting unit on the substrate and generating light;
an encapsulation layer covering the light emitting unit; and
a coating layer including an organic material and on the encapsulation layer,
wherein a refractive index of the coating layer is greater than a refractive index of air and less than a refractive index of the encapsulation layer.

2. The light emitting diode of claim 1, wherein
the coating layer includes at least one of oleic acid, palmitic acid, eicosenoic acid, and erucic acid.

3. The light emitting diode of claim 2, wherein
the encapsulation layer includes a phosphor therein.

4. The light emitting diode of claim 3, wherein
the phosphor is an oxide group compound or a nitride group compound.

5. The light emitting diode of claim 4, wherein
the phosphor includes a nitride crystal or oxynitride crystal comprising europium (Eu) among a crystal having a β type silicon nitride (Si₃N₄) crystal structure.

6. The light emitting diode of claim 4, wherein
the phosphor includes at least one of (Ba,Sr,Ca)₂SiO₄:Eu₂+, Ba₂MgSi₂O₇:Eu₂+, Ba₂ZnSi₂O₇:Eu₂+, BaAl₂O₄:Eu₂+, SrAl₂O₄:Eu₂+, BaMgAl₁₀O₁₇:Eu₂+, Mn₂+, and BaMg₂Al₁₆O₂₇:Eu₂+ of a green wavelength range.

7. The light emitting diode of claim 4, wherein
the phosphor includes at least one of BaMg₂Al₁₆O₂₇:Eu₂+, Sr₄Al₁₄O₂₅:Eu₂+, BaAl₁₈O₁₃:Eu₂+, (Sr,Mg,Ca,Ba)₅(PO₄)₃Cl:Eu₂+, and Sr₂Si₃O₈ - 2SrCl₂:Eu₂+ of a blue wavelength range.

8. The light emitting diode of claim 4, wherein
the phosphor includes at least one of Y₂O₃:Eu₃+, Bi₃+,
(Sr,Ca,Ba,Mg,Zn)₂P₂O₇:Eu₂⁺, Mn₂+, (Ca,Sr,Ba,Mg,Zn)₁₀(PO₄)₆(F,Cl,Br,OH)₂:Eu₂+, Mn₂+, (Gd,Y,Lu,La)₂O₃:Eu₃+, Bi₃+, (Gd,Y,Lu,La)BO₃:Eu₃+, Bi₃+, (Gd,Y,Lu,La)(P,V)O₄:Eu₃+, Bi₃+, (Ba,Sr,Ca)MgP₂O₇:Eu₂+, Mn₂+, (Y,Lu)₂WO₆:Eu₃+, Mo₆+, (Sr,Ca,Ba,Mg,Zn)₂SiO₄:Eu₂+, and Mn₂+ as an oxide group, or (Sr,Ca)AlSiN₃:Eu₂+, (Ba,Sr,Ca)₂Si₅N₈:Eu₂+, or (Ba,Sr,Ca)₂SiO₄₋ₓN_{y}:Eu₂+ as a nitride group of a red wavelength range.

9. The light emitting diode of claim 1, wherein
the encapsulation layer includes an epoxy resin or silicon resin.

10. The light emitting diode of claim 9, wherein
the light which is generated by the light emitting unit passes through the encapsulation layer and the coating layer in sequence.

11. The light emitting diode of claim 1, wherein
the coating layer includes a lower layer, and an upper layer disposed on the lower layer, and
the upper layer includes a material having a lower refractive index than a material of the lower layer.

12. The light emitting diode of claim 1,
further comprising a mold frame on an upper surface of the substrate,
and
the light emitting unit and the encapsulation layer are inside the mold frame.

13. The light emitting diode of claim 12, wherein
the coating layer is extended from the encapsulation layer and overlaps a portion of a lateral side of the mold frame.

14. The light emitting diode of claim 1, wherein
the encapsulation layer includes dual layers having different refractive indexes.

15. The light emitting diode of claim 14, wherein
the encapsulation layer includes a lower encapsulation layer covering the light emitting unit, and
an upper encapsulation layer on the lower encapsulation layer, and
a refractive index of the upper encapsulation layer is smaller than a refractive index of the lower encapsulation layer.
